# EUROPEAN PATENT APPLICATION

(11) **EP 4 658 012 A1**
(43) Date of publication of application: **03.12.2025**
(21) Application number: 24898942.8
(22) Date of filing: 15.10.2024
(51) Int. Cl.: H10B 12/00

(54) **SEMICONDUCTOR STRUCTURE AND PREPARATION METHOD THEREFOR**

(30) Priority: 15.04.2024 CN 202410452734
(71) Applicant: CXMT Corporation, Hefei, Anhui 230601 (CN)
(72) Inventor: JANG, Semyeong, Hefei, Anhui 230601 (CN); JUNG, Bochul, Hefei, Anhui 230601 (CN); CHEN, Muyu, Hefei, Anhui 230601 (CN); MOON, Joonsuk, Hefei, Anhui 230601 (CN); CHO, Young Chan, Hefei, Anhui 230601 (CN)
(74) Representative: Gulde & Partner
(86) International application number: PCT/CN2024/125016
(87) International publication number: WO 2025/218129

(57) **Abstract**

Disclosed are a semiconductor structure and a manufacturing method therefor. The semiconductor structure includes bit lines, wherein the bit lines extend in a first direction and are spaced apart from each other in a second direction, and the first direction intersects the second direction; shield lines that are each located between two adjacent bit lines, extend in the first direction, and are arranged alternately with the bit lines in the second direction; active pillars, where the active pillars are located on the bit lines and arranged in an array in the first direction and the second direction; and bit line contact structures that are located between the bit lines and the active pillars and connect the bit lines and the active pillars, where a width of each bit line contact structure in the second direction is less than widths of each bit line and each active pillar in the second direction.

## Description

The present disclosure claims priority to Chinese Patent Application No. 202410452734.7 filed with China National Intellectual Property Administration on April 15, 2024 and entitled "SEMICONDUCTOR STRUCTURE AND MANUFACTURING METHOD THEREFOR", the content of which is incorporated herein by reference in its entirety.

### TECHNICAL FIELD

The present disclosure relates to the technical field of integrated circuits, in particular to a semiconductor structure and a manufacturing method therefor.

### BACKGROUND

With the advancement of dynamic random access memory (DRAM) technology, the sizes of memory cells have increasingly decreased. The array architecture of a memory cell has evolved from 8F² to 6F², and then to 4F² (F represents the minimum feature size achievable in a given process condition).

However, in a structure with the 4F² design, how to reduce the area of a transistor in a single array region as much as possible to achieve higher chip area utilization still remains an urgent problem to be solved.

### SUMMARY

In view of the above-described, the present disclosure provides a semiconductor structure and a manufacturing method therefor to reduce the volume of the device and reduce the difficulty of the manufacturing process.

In one aspect, the present disclosure provides a semiconductor structure according to some embodiments, including:
active pillars arranged in an array in a first direction and a second direction, where the first direction intersects the second direction;
bit lines that extend in the first direction, are spaced apart from each other in the second direction, and are connected to active pillars arranged along the first direction;
shield lines that are each located between two adjacent bit lines, extend in the first direction, and are arranged alternately with the bit lines in the second direction; and
bit line contact structures that are located between the bit lines and the active pillars and connect the bit lines and the active pillars, where a width of each of the bit line contact structures in the second direction is less than widths of each of the bit lines and each of the active pillars in the second direction.

In some embodiments, each of the bit line contact structures is connected to two of the active pillars that are adjacent to each other in the second direction.

In some embodiments, a width of each of the shield lines in a third direction is not less than a width of each of the bit lines in the third direction, and the third direction intersects the first direction and the second direction.

In some embodiments, the width of each of the bit lines decreases as the bit line extends towards the bit line contact structure.

In some embodiments, the semiconductor structure further includes:
bit line protective layers, where the bit line protective layers are each located on a side of one bit line away from the bit line contact structure; and
bit line isolation layers, where the bit line isolation layers are each located between two adjacent bit lines, and the shield lines are located in the bit line isolation layers, where
the bit line protective layers and the bit line isolation layer are made of different materials.

In some embodiments, each of the bit lines includes at least one layer made of a metal material; and
each of the shield lines includes at least one layer made of a metal material.

In some embodiments, the semiconductor structure further includes:
shield line barrier layers, where the shield line barrier layers cover the shield lines.

In some embodiments, there is a void between each of the bit line isolation layers and each of the shield lines.

In some embodiments, a cross-sectional shape of each of the shield lines perpendicular to the first direction is pyramidal, elongated, elliptical, star-shaped, or other suitable shapes.

In some embodiments, the semiconductor structure further includes:
word lines, where the word lines extend in the second direction and are spaced apart from each other in the first direction, and the word lines are connected to active pillars in the second direction; and
a memory structure, where the memory structure is connected to the active pillars and is located at one end of the active pillars away from the bit lines.

In another aspect, the present disclosure further provides a method for manufacturing a semiconductor structure according to some embodiments, including:
forming active pillars, where the active pillars are arranged in an array in a first direction and a second direction, and the first direction intersects the second direction;
forming bit lines, where the bit lines extend in the first direction, are spaced apart from each other in the second direction, and are connected to active pillars arranged along the first direction;
forming shield lines, where the shield lines are each located between two adjacent bit lines, extend in the first direction, and are arranged alternately with the bit lines in the second direction; and
forming bit line contact structures, where the bit line contact structures connect the bit lines and the active pillars, and a width of each of the bit line contact structures in the second direction is less than widths of each of the bit lines and each of the active pillars in the second direction.

In some embodiments, forming the bit lines includes:
providing a substrate, where the substrate has a first surface and a second surface in a third direction, and the third direction intersects the first direction and the second direction;
forming bit line isolation trenches by graphically etching the first surface, where a size of a bottom of each of the bit line isolation trenches is greater than a size of a top of the bit line isolation trench, and the bit line isolation trenches extend along the first direction and are spaced apart from each other in the second direction;
filling the bit line isolation trenches to form bit line isolation layers;
polishing the second surface to expose the bit line isolation layers, and etching the substrate with the bit line isolation layers as masks to form bit line trenches;
filling at least one layer made of a metal material into each of the bit line trenches to form one bit line; and
forming bit line protective layers on the bit lines, where the bit line protective layers and the bit line isolation layers are made of different materials.

In some embodiments, forming the shield lines includes:
etching the bit line isolation layers on the second surface with the bit line protective layers as mask layers to form shield line trenches, where a depth of each of the shield line trenches is not less than a depth of each of the bit line trenches; and
filling at least one layer made of a metal material into each of the shield line trenches to form one shield line.

In some embodiments, each of the bit line contact structures includes a metal silicide, and forming the metal silicide includes:
depositing a metal material layer at a bottom of each of the bit line trenches, and performing high-temperature treatment to form the metal silicide; or
depositing a metal material layer at a bottom of each of the bit line isolation trenches, and performing high-temperature treatment to form the metal silicide.

In some embodiments, after filling the bit line isolation trenches to form the bit line isolation layers, the method further includes:
forming word line isolation trenches by graphically etching the first surface, where a depth of each of the word line isolation trenches is less than a depth of each of the bit line isolation trenches, the word line isolation trenches extend along the second direction and are spaced apart from each other in the first direction, and the word line isolation trenches and the bit line isolation trenches form the active pillars; and
after forming the active pillars, the method further includes:
   forming word lines in the word line isolation trenches, where the word lines extend in the second direction and are spaced apart from each other in the first direction, and the word lines are connected to active pillars in the second direction; and
   forming a memory structure at one end of the active pillars away from the bit lines.

The semiconductor structure and the manufacturing method therefor provided in the present disclosure have at least the following beneficial effects.

According to the semiconductor structure and the manufacturing method therefor provided in the present disclosure, the bit line resistance can be reduced by forming a metal bit line on the back of a wafer, and the coupling capacitance between adjacent bit lines can be reduced by forming a metal shield line between bit lines, such that the stability of the device is improved. Since the substrate, the bit line isolation layers, and the bit line protective layers are made of different materials, different etching selectivities are set, and the number of photomasking can be reduced through a self-aligned etching process for etching, such that production costs are reduced. In addition, adjacent active pillars can share one bit line, such that the process difficulty of the apparatus can be reduced.

### BRIEF DESCRIPTION OF THE DRAWINGS

To more clearly illustrate technical solutions in embodiments of the present disclosure or the conventional technology, a brief introduction to the accompanying drawings required for the description of the embodiments or conventional technology is given hereinafter. It is evident that the accompanying drawings described hereinafter are merely some embodiments of the present disclosure. For those of ordinary skill in the art, other drawings may further be obtained based on these drawings without creative effort.
FIG. 1a is a schematic top view of a semiconductor structure according to some disclosed embodiments, and FIG. 1b and FIG. 1c are schematic structural diagrams showing cross-sectional views along directions of bit lines and word lines, respectively;
FIG. 2 is a schematic structural diagram showing a cross-sectional view of a semiconductor structure along a direction of word lines according to some embodiments of the present disclosure;
FIG. 3a to FIG. 3e are schematic structural diagrams showing cross-sectional views of a semiconductor structure along a direction of word lines according to some other embodiments of the present disclosure;
FIG. 4a to FIG. 4l are schematic structural diagrams showing cross-sectional views along a direction of word lines in each phase of a method for manufacturing a semiconductor structure according to some embodiments of the present disclosure; and
FIG. 5a to FIG. 5f are schematic structural diagrams showing cross-sectional views along a direction of word lines in each phase of a method for manufacturing a semiconductor structure according to some other embodiments of the present disclosure.

Reference numerals in the figures are as follows:
1: substrate; 2: word line; 3: bit line; 4: active pillar; 5: word line isolation trench; 6: bit line isolation trench; 601: initial bit line isolation trench; 602: first bit line isolation trench; 603: second bit line isolation trench; 7: sidewall protective layer; 8: bit line isolation layer; 9: memory contact; 10: bit line contact structure; 11: memory structure; 12: bit line trench; 13: bit line material layer; 301: bit line first-material layer; 302: bit line second-material layer; 14: bit line protective layer; 15: shield line trench; 16: shield line; 1601: shield line first-material layer; 1602: shield line second-material layer; 17: void; and 18: shield line barrier layer.

### DETAILED DESCRIPTION

To facilitate understanding of the present disclosure, a more comprehensive description of the present disclosure will be provided hereinafter with reference to the relevant drawings. The accompanying drawings illustrate the preferred embodiments of the present disclosure. However, the present disclosure can be implemented in many different forms and is not limited to the embodiments described herein. Rather, these embodiments are provided to make the disclosed contents in the present disclosure more thorough and comprehensive.

Unless otherwise defined, all technical and scientific terms used herein have the same meaning as commonly understood by those skilled in the art to which the present disclosure belongs. The terms used in the specification of the present disclosure are merely for the purpose of describing particular embodiments and are not intended to limit the present disclosure.

It should be understood that when an element or layer is referred to as being "on", "adjacent to", or "connected to" another element or layer, it may be directly on, adjacent to, or connected to the another element or layer, or an intervening element or layer may be present. It should be appreciated that, although the terms first, second, and the like may be used to describe various elements, components, regions, layers, doping types, and/or portions, the elements, components, regions, layers, doping types, and/or portions should not be limited by these terms. These terms are only used to distinguish one element, component, region, layer, doping type, or portion from another element, component, region, layer, doping type, or portion. Therefore, a first element, component, region, layer, doping type, or portion discussed hereinafter may be termed a second element, component, region, layer, or portion without departing from the teachings of the present disclosure. For example, a first doped region may be referred to as a second doped region, and similarly, a second doped region may be referred to as a first doped region; the first doped region is different from the second doped region.

Spatial relationship terms such as "on" may be used herein to describe a relationship between one element or feature and another element or feature as illustrated in the drawings. It should be understood that the spatial relationship terms include different orientations of a device in use or operation in addition to an orientation illustrated in the drawings. For example, if the device in the drawings is turned over, an element or feature described as "on" another element or feature would be oriented "under" the another element or feature. Therefore, the exemplary term "on" may include both upward and downward orientations. In addition, the device may further include additional orientations (for example, rotated 90 degrees or other orientations), and the spatial descriptive terms used herein should be interpreted accordingly.

As used herein, the singular forms "a", "an", and "the" may include the plural forms as well, unless otherwise clearly indicated in the context. It should further be understood that the terms "comprise" and/or "include", when used in the specification, specify the presence of stated features, integers, steps, operations, elements, and/or components, but do not preclude the presence or addition of one or more other features, integers, steps, operations, elements, components, and/or groups. Additionally, as used herein, the term "and/or" includes any and all combinations of the associated listed items.

The embodiments of the present disclosure are described herein with reference to the schematic cross-sectional views of the ideal embodiments (and intermediate structures) of the present disclosure, such that variations in the shapes shown are to be expected, for example, due to manufacturing techniques and/or tolerances. Therefore, the embodiments of the present disclosure should not be limited to specific shapes of regions shown herein, but should include shape deviations resulting from manufacturing techniques. The regions shown in the drawings are essentially illustrative, and the shapes do not represent actual shapes of the regions of the device, and do not limit the scope of the present disclosure.

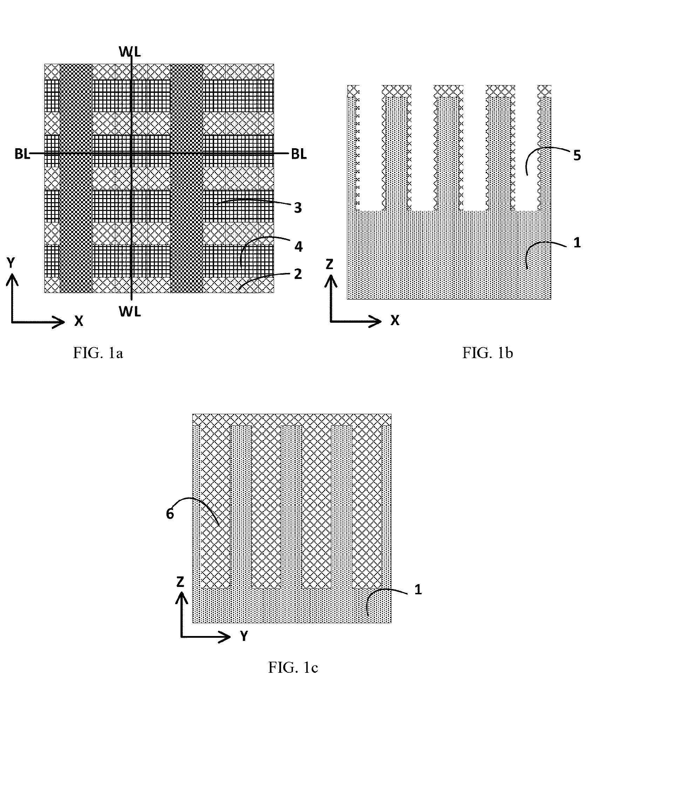

With reference to FIG. 1a, in some related embodiments, a semiconductor structure may include a plurality of bit lines (BL) 3, a plurality of word lines (WL) 2, and a plurality of active pillars 4, where the bit lines may extend along a first direction (for example, an X-direction) and be arranged along a second direction (for example, a Y-direction), the words lines may extend along the second direction and be arranged along the first direction, the bit lines 3 and the word lines 2 intersect at the active pillars 4 in space, and the plurality of active pillars may extend along a third direction (for example, a Z-direction) perpendicular to a direction of a substrate 1 and be arranged in an array. When the bit lines 3 are manufactured, bit line isolation trenches 6 are first formed and filled, referring to FIG. 1c, and then word line isolation trenches 5 are formed by etching, referring to FIG. 1b. The substrate is modified through ion implantation, doping, or metal diffusion in the word line isolation trenches to form the bit lines 3. Since the size of the bit line 3 becomes increasingly smaller, the resistance of the bit line 3 becomes increasingly larger. Further, the distance between adjacent bit lines 3 becomes increasingly smaller, and a corresponding coupling effect becomes increasingly larger, greatly affecting the performance of the semiconductor structure. In addition, a certain damage will be caused to the word line isolation trenches, a memory contact, the active pillars, and the like during the process of forming the bit lines 3, which greatly limits the development of a semiconductor structure manufacturing process.

The present disclosure provides a semiconductor structure and a manufacturing method therefor, which can reduce the volume of the device. Details thereof are described in the following embodiments.

In one aspect, the present disclosure provides a semiconductor structure according to some embodiments.

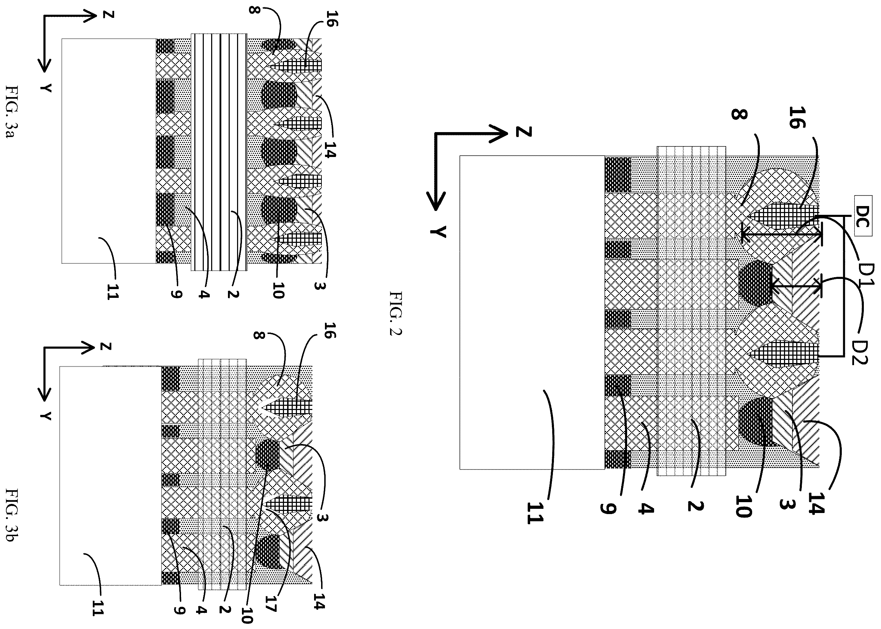

With reference to FIG. 2, in some embodiments, the semiconductor structure may include a plurality of bit lines 3, a plurality of active pillars 4, a plurality of shield lines 16, and bit line contact structures 10. The plurality of bit lines 3 extend in a first direction (for example, an X-direction) and are spaced apart from each other in a second direction (for example, a Y-direction), where the first direction intersects the second direction; the plurality of shield lines 16 are each located between two adjacent bit lines 3, extend in the first direction, and are arranged alternately with the bit lines 3 in the second direction; the plurality of active pillars 4 extend in a third direction (for example, a Z-direction) away from the bit lines 3 and are arranged in an array in the first direction and the second direction; the bit line contact structures 10 are each located between the bit line 3 and the active pillar 4 and connect the bit lines 3 and the active pillars 4, where the width of the bit line contact structure 10 in the second direction is less than the widths of the bit line and the active pillar in the second direction.

In the semiconductor structure provided in the above embodiments, the shield lines 16 are each located between adjacent bit lines 3 and are arranged alternately with the bit lines in the second direction. The shield line 16 can reduce the coupling effect between two adjacent bit lines 3, thereby ensuring the stability of the semiconductor structure. The width of the bit line contact structure 10 in the second direction is less than the widths of the bit line 3 and the active pillar 4 in the second direction, such that the width of the bit line 3 in the second direction can be increased, the resistance of the bit line 3 is reduced, and the manufacturing difficulty of the bit line 3 is reduced.

With reference to FIG. 2 and FIG. 3a, in some embodiments, one bit line contact structure may be connected to one active pillar 4, or one bit line contact structure 10 may be connected to two active pillars 4 adjacent to each other in the second direction. With reference to FIG. 2, that is, two adjacent active pillars 4 share one bit line contact structure 10 and one bit line 3, such that the bit line density can be reduced, the integration degree can be increased, and the distance between the bit lines can be increased. In addition, the width of the bit line 3 can be increased, the resistance of the bit line 3 can be reduced, and the performance of the device can be improved.

With further reference to FIG. 2, in some embodiments, the width D1 of the shield line 16 in the third direction (for example, the Z-direction) is not less than the width D2 of the bit line 3 in the third direction (for example, the Z-direction), or the width D1 of the shield line 16 in the third direction (for example, the Z-direction) exceeds the width D2 of the bit line 3 in the third direction (for example, the Z-direction). Optionally, the width D1 of the shield line 16 in the third direction (for example, the Z-direction) exceeds a sum of the widths of the bit line 3 and the bit line contact structure 10 in the third direction (for example, the Z-direction), such that the shield line 16 can completely shield the coupling effect between adjacent bit lines 3, thereby improving the performance of the device.

With further reference to FIG. 2, in some embodiments, the width of the bit line 3 in the second direction (for example, the Y-direction) decreases as the bit line extends towards the bit line contact structure. This can be understood as that the bit line is in an inverted trapezoidal shape, such that the resistance of the bit line 3 can be reduced, and the manufacturing process difficulty of the bit line 3 can be reduced.

With further reference to FIG. 2, in some embodiments, the semiconductor structure may include bit line protective layers 14 and bit line isolation layers 8. The bit line protective layers 14 are each located on a side of one bit line 3 away from the bit line contact structure 10, extend along the first direction (for example, X), and are arranged in the second direction (for example, Y). Each bit line isolation layer 8 is located between adjacent bit lines 3 to insulate and isolate the adjacent bit lines. The materials of the bit line protective layers 14 and the bit line isolation layers 8 are not particularly limited. As an example, the material of the bit line protective layers 14 may include, but are not limited to, silicon nitride, silicon oxide, silicon oxynitride, silicon carbonitride, and the like, or a combination thereof, and the material of the bit line isolation layers 8 may include, but are not limited to, silicon nitride, silicon oxide, silicon oxynitride, silicon carbonitride, and the like, or a combination thereof. However, the bit line isolation layers 8 and the bit line protective layers 14 must be made of different materials. For example, the bit line protective layers 14 may be made of silicon nitride, and the bit line isolation layers may be made of silicon oxide, such that when the bit line isolation layers 8 are etched, the bit line isolation layers 8 can be selectively etched with the bit line protective layers 14 as masks by a self-aligned method, which can reduce the process difficulty and costs.

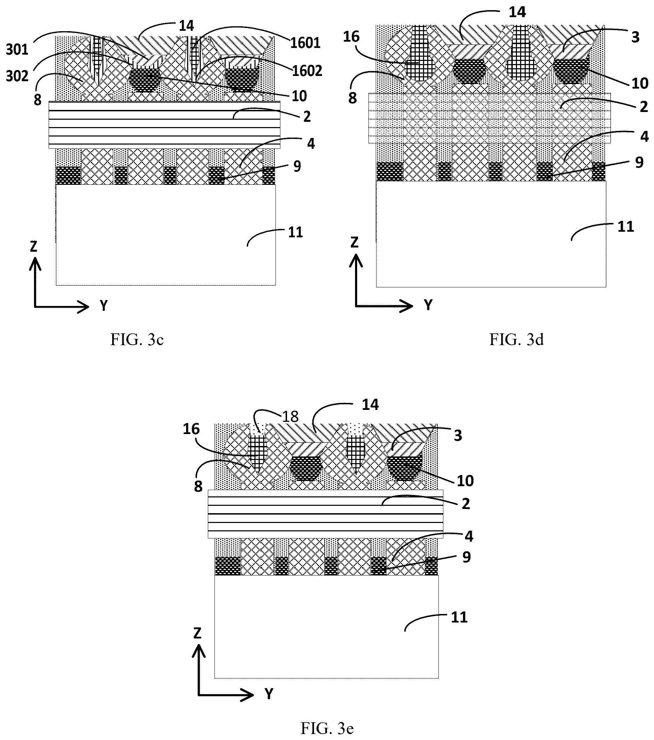

With further reference to FIG. 2 and FIG. 3c, in some embodiments, the bit line 3 and the shield line 16 may each have a single layer, or may each have a plurality of layers. For example, in FIG. 3c, the bit line 3 includes a bit line first-material layer 301 and a bit line second-material layer 302, where the position relationship between the bit line first-material layer 301 and the bit line second-material layer 302 is not particularly limited. As an example, the bit line first-material layer 301 and the bit line second-material layer 302 may be in a stacked, surrounded, or half-surrounded relationship. The shield line 16 may include a shield line first-material layer 1601 and a shield line second-material layer 1602, where the position relationship between the shield line first-material layer 1601 and the shield line second-material layer 1602 is not particularly limited. As an example, the shield line first-material layer 1601 and the shield line second-material layer 1602 may be in a stacked, surrounded, or half-surrounded relationship. The materials of the bit lines 3 and the shield lines 16 are not particularly limited. As an example, the material of the bit lines 3 may include, for example, doped polycrystalline silicon, metal, conductive metal nitride, conductive metal silicide, conductive metal oxide, or a combination thereof. For example, the bit lines 3 may include, but are not limited to, doped polycrystalline silicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, or a combination thereof. The material of the shield lines 16 may include, for example, doped polycrystalline silicon, metal, conductive metal nitride, conductive metal silicide, conductive metal oxide, or a combination thereof. For example, the shield lines 16 may include, but are not limited to, doped polycrystalline silicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, or a combination thereof. Each bit line 3 and each shield line 16 include at least one metal material layer, such that the resistances of the bit line 3 and the shield line 16 can be reduced, and the performance of the device can be improved.

With further reference to FIG. 2, in some embodiments, the semiconductor structure may include a direct current bias (DC bias) power supply. The DC bias power supply and the shield lines 16 may be in contact through a connection (not shown) to provide a stable voltage to the shield line 16, such that the shield line 16 forms a conductive barrier, and thus when one of two adjacent bit lines 3 is powered on or off, the other bit line is less affected or unaffected.

With reference to FIG. 3b, in some embodiments, at least parts of each shield line 16 and each bit line isolation layer 8 are not in full contact, and there is a void 17 between the shield line 16 and the bit line isolation layer 8. The position of the void 17 relative to the shield line 16 and the bit line isolation layer 8 is not particularly limited. As an example, the void 17 may be located at the bottom or on one sidewall of the shield line, half-surround the shield line, or the like. The size and the shape of the void 17 are also not particularly limited. As an example, the void may be in the shape of a sphere, a droplet, a short tube, an ellipsoid, or a strip, or in other suitable shapes. Because the dielectric constant of the air is 1.001 and is close to the dielectric constant of vacuum, the void 17 and the bit line isolation layer 8 together demonstrate an effect of a low dielectric constant to reduce the overall dielectric constant, such that the parasitic capacitance can be reduced, and the capacitive coupling effect between the bit line 3 and an adjacent bit line 3 can be avoided, thereby reducing the influence of the parasitic capacitance on the performance parameter of the device.

With reference to FIG. 3d, in some embodiments, the cross-sectional shape of the shield line 16 perpendicular to the first direction is the shape of an irregular structure, for example, may be pyramidal, elongated, elliptical, star-shaped, or other suitable shapes. The shield line is formed in the bit line isolation layer 8, and the size of the shield line 16 is influenced by the material of the bit line isolation layer 8 and the etching capability of the apparatus. The irregular structure of the shield line 16 can increase the process manufacturing window and reduce manufacturing process costs.

With reference to FIG. 3e, in some embodiments, shield line barrier layers 18 may be further disposed above the shield lines 16, where the shield line barrier layers 18 cover the shield lines 16 and thus protect the shield lines 16 from being damaged in a subsequent process. The material of the shield line barrier layers 18 is not limited and may be the same as or different from the material of the bit line protective layers 14.

With further reference to FIG. 2 and FIG. 3a to 3e, in some embodiments, the semiconductor structure further includes word lines 2, memory contacts 9 each at one end of one active pillar, a memory structure 11, and a back end connection line and a protective layer (not shown) located on the memory structure 11. Specifically, the word lines 2 extend along the second direction and are arranged in the first direction. The word lines surround the active pillars 4 and control the charge movement of the active pillars 4 on one, two, or three sides of the active pillars. The material of the word lines is not particularly limited. As an example, the material of the word lines 2 may include, for example, doped polycrystalline silicon, metal, conductive metal nitride, conductive metal silicide, conductive metal oxide, or a combination thereof. For example, the word lines 2 may include, but are not limited to, doped polycrystalline silicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, or a combination thereof.

The memory contacts 9 are each located at one end of one active pillar 4 away from the bit line contact structure 10 and connect the active pillars 4 and the memory structure 11. The material of the memory contacts 9 is not particularly limited. As an example, the material of the memory contacts 9 may include at least one of doped polycrystalline silicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, and a combination thereof, such that the contact resistance between the active pillars 4 and the memory structure 11 can be reduced.

The memory structure 11 may be a capacitor structure. The capacitor includes upper and lower electrode plates and a high-K dielectric material between the upper and lower electrode plates; or may be a variable resistance memory structure. The variable resistance memory structure switches between two resistance states through the electric pulse applied to the memory element. For example, the variable resistance memory structure may include a phase change material, a perovskite compound, a transition metal oxide, a magnetic material, a ferromagnetic material, or an anti-ferromagnetic material, the crystalline state of which changes based on the amount of current.

In another aspect, the present disclosure further provides a method for manufacturing a semiconductor structure according to some embodiments. To more clearly illustrate the method for manufacturing a semiconductor structure in some embodiments of the present disclosure, refer to FIG. 1 to FIG. 3 for understanding some embodiments of the present disclosure.

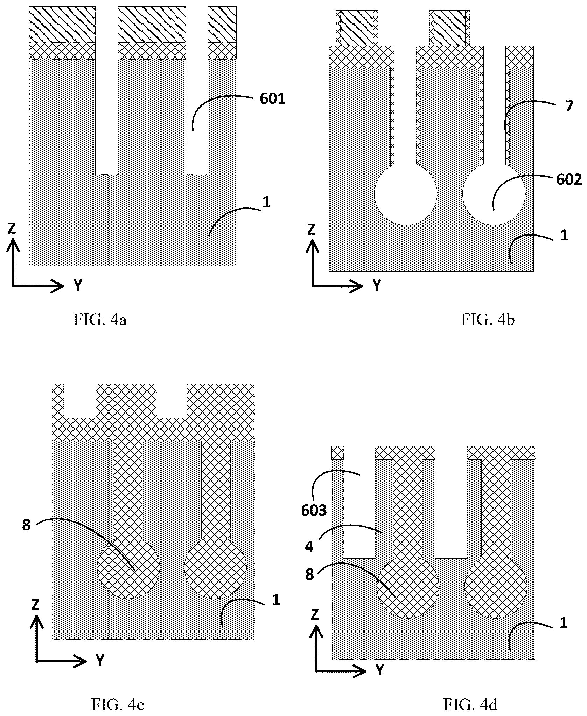

FIG. 4a to FIG. 4l are views showing intermediate steps describing a method for manufacturing a semiconductor memory device according to some embodiments.

With reference to FIG. 4a, a substrate 1 is provided. The substrate has a first surface and a second surface opposite each other in a third direction (for example, a Z-direction), and initial bit line isolation trenches 601 are formed by graphically etching the first surface.

Specifically, in some embodiments, the material of the substrate 1 is not particularly limited. As an example, the material of the substrate 1 may include silicon (Si), silicon germanium (SiGe), silicon germanium carbon (SiGeC), silicon carbide (SiC), gallium arsenide (GaAs), indium arsenide (InAs), indium phosphide (InP), other III/V semiconductor materials or II/VI semiconductor materials, or the like.

In some embodiments, forming the initial bit line isolation trenches 601 by graphically etching may include: forming a mask layer on the first surface of the substrate 1, where the mask layer may include one, two, or a plurality of material layers; depositing a photoresist layer; and etching the mask layer and the substrate 1 after exposure and development to form the initial bit line isolation trenches 601. The etching method may be dry etching, may be wet etching, or may be a mixture of the two, which is not particularly limited. With reference to FIG. 2 and FIG. 3a, one column of active pillars 4 may be connected to one column of bit lines 3, or two adjacent columns of active pillars 4 may share one column of bit lines 3. In the case that two adjacent columns of active pillars 4 share one bit line, the space between adjacent bit lines can be reduced to reduce the volume of the device, and the internal layout of the semiconductor structure can be more reasonable, thereby effectively improving the storage density of the semiconductor structure. In the embodiments, two columns of active pillars 4 sharing one bit line 3 are taken as an example, and double spacing is adopted between the formed initial bit line isolation trenches 601, that is, the spacing between the adjacent initial bit line isolation trenches 601 is twice the distance between the active pillar 4 and one bit line isolation trench 6, such that the process manufacturing window is increased, and the performance stability of the device is improved.

With reference to FIG. 4b, in some embodiments, a part of the mask layer, which is not removed by etching, is modified, such that the size and the dimension thereof fit the width of the bit line isolation trench 6, or the width of an exposed part of the substrate, which is not etched, is equivalent to the width of the active pillar 4. The width is not particularly limited, and may be, for example, any width between 10 nm to 40 nm according to the process requirement. Sidewall protective layers 7 are deposited in the initial bit line isolation trenches 601 and on the first surface of the substrate and the surface of a part of the mask layer on the first surface of the substrate, which is not removed by etching. The sidewall protective layers 7 can protect the first surface of the substrate and the surface of the part of the mask layer on the first surface of the substrate, which is not removed by etching, from being damaged in a subsequent process. The sidewall protective layers 7 are etched to open sidewall protective layers at the bottoms of the initial bit line isolation trenches 601, and then same-direction etching is performed to form first bit line isolation trenches 602. The same-direction etching may be dry etching, may be wet etching, or may be a mixture of the two, which is not particularly limited. Since the same-direction etching is adopted, the width of the first bit line isolation trench 602 in the second direction is greater than the width of the initial bit line isolation trench 601 in the second direction, and parts of the substrate on two sides of the first bit line isolation trench 602 are removed by etching.

With reference to FIG. 4c, in some embodiments, the initial bit line isolation trenches 601 and the first bit line isolation trenches 602 are filled with an insulating material, and a planarization process is performed to expose a part of the mask layer, which is not removed by etching. Specifically, in some embodiments, the insulating material may include, but is not limited to, silicon nitride, silicon oxide, silicon oxynitride, silicon carbonitride, and the like, or a combination thereof, and the insulating material is different from the material of the mask layer. The deposition method may include, but is not limited to, a chemical vapor deposition method, a flowable chemical vapor deposition method, an atomic layer deposition method, a spin coating method, and a high strength deposition method, or a combination thereof. The part of the mask layer, which is not removed, is selectively etched. Since the mask layer and the bit line isolation layers 8 are made of different materials, a self-aligned method is adopted for etching, without photomasking. The etching method may be dry etching, may be wet etching, or may be a mixture of the two. The mask layer may be modified, such that the size thereof is consistent with that of the bit line isolation trench 6. The pattern of second bit line isolation trenches 603 is formed after the mask layer is removed.

With reference to FIG. 4d, in some embodiments, the second bit line isolation trenches 603 are formed based on the pattern of the second bit line isolation trenches 603 formed in the foregoing step. The second bit line isolation trenches 603 extend along the first direction, are each located between adjacent first bit line isolation trenches 602, and are spaced apart from the first bit line isolation trenches 602 in the second direction. Since the first bit line isolation trenches 602 and the second bit line isolation trenches 603 are spaced apart from each other and formed in different steps, when the first bit line isolation trench 602 and the second bit line isolation trench 603 are separately manufactured, the distance between adjacent bit line isolation trenches 6 is large, such that the process manufacturing window is increased, and the stability of the device is improved.

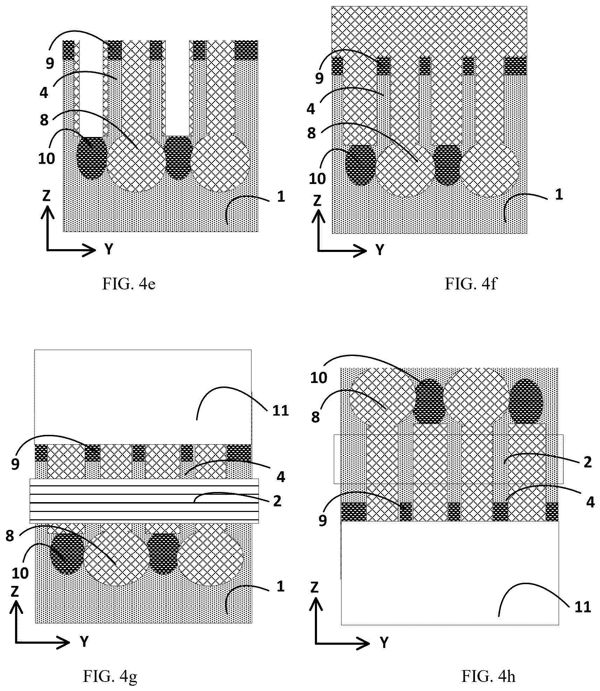

With reference to FIG. 4e, in some embodiments, bit line contact structures 10 are each formed at the bottom of one second bit line isolation trench 603, and memory contacts 9 are each formed at the top of one active pillar. Each bit line contact structure 10 is located at the bottom of one second bit line isolation trench 603, is connected to the substrate on two sides, and is in contact with an adjacent first bit line isolation trench 602 in the second direction. Specifically, sidewall protective layers are formed in the second bit line isolation trenches 603 and the surface of the substrate to prevent the substrate from being damaged or affected in a subsequent process; the protective layers at the bottoms of the second bit line isolation trenches 603 and the surface of the substrate are removed by etching to expose the substrate; the bit line contacts 10 and the memory contacts 9 are formed by a suitable method, for example, ion implantation, deposition of a high-concentration doping material for diffusion, or deposition of a metal material for metal silicification reaction. The bit line contacts 10 and the memory contacts 9 may be formed in different steps, or may be formed in one step, which is not particularly limited. The material of the memory contacts 9 is not particularly limited. As an example, the material of the memory contacts 9 may include at least one of doped polycrystalline silicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, and a combination thereof. The material of the bit line contacts 10 is not particularly limited. As an example, the material of the bit line contacts 10 may include at least one of doped polycrystalline silicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, and a combination thereof.

With reference to FIG. 4f, in some embodiments, the second bit line isolation trenches 603 are filled with an insulating material to form the bit line isolation layers 8, and a planarization process is performed. The bit line isolation layers 8 extend along the first direction and are spaced apart from each other in the second direction.

With reference to FIG. 1b and FIG. 4g, in some embodiments, word line isolation trenches 5 are formed by graphically etching the first surface of the substrate. The word line isolation trenches 5 and the bit line isolation trenches 6 form the active pillars 4. Word lines 2 are formed in the word line isolation trenches 5, and the word lines 2 extend along the second direction and are arranged in the first direction. The word lines surround the active pillars 4 and control the charge movement of the active pillars 4 on one, two, or three sides of the active pillars. The material of the word lines is not particularly limited. As an example, the material of the word lines 2 may include, for example, doped polycrystalline silicon, metal, conductive metal nitride, conductive metal silicide, conductive metal oxide, or a combination thereof. For example, the word lines 2 may include, but are not limited to, doped polycrystalline silicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, or a combination thereof.

A memory structure 11 is formed on the memory contacts 9, and a back end connection line (not shown) is formed on the memory structure 11. The memory structure 11 may be a capacitor structure. The capacitor includes an upper electrode plate, a lower electrode plate, and a high-K dielectric material between the upper electrode plate and the lower electrode plate; or may be a variable resistance memory structure. The variable resistance memory structure switches between two resistance states through the electric pulse applied to the memory element. For example, the variable resistance memory structure may include a phase change material, a perovskite compound, a transition metal oxide, a magnetic material, a ferromagnetic material, or an anti-ferromagnetic material, the crystalline state of which changes based on the amount of current.

With reference to FIG. 4h, in some embodiments, the substrate is turned over, and the second surface of the substrate is thinned through a polishing process with the bit line isolation layers 8 as etch stop layers.

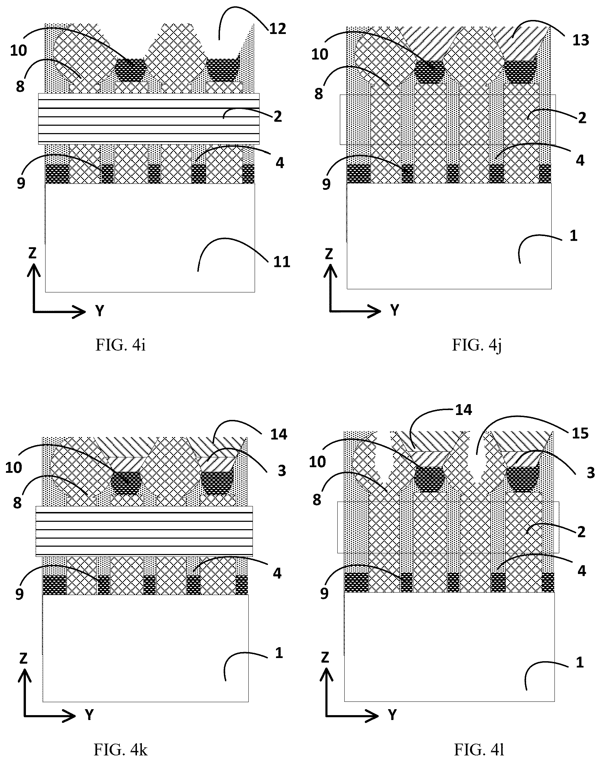

With reference to FIG. 4i, in some embodiments, since the bit line isolation layers 8 and the substrate are made of different materials, a self-aligned process may be adopted to selectively etch and remove a part of the substrate material to form bit line trenches 12. The self-aligned process can reduce the number of exposure and process costs.

With reference to FIG. 4j, in some embodiments, bit line material layers 13 are deposited in the bit line trenches 12, and the bit line material is not particularly limited. As an example, the bit line material layers 13 may include, but are not limited to, doped polycrystalline silicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, or a combination thereof.

With reference to FIG. 4k, in some embodiments, the bit line material layers 13 are etched back to form the bit lines 3, and bit line protective layers 14 are formed on the bit lines 3, where the bit line protective layers 14 are planarized through a grinding process. Specifically, a selective etching method is adopted to etch and remove a part of the bit line material layer 13, such that the bit line material layer 13 is only formed in the bit line trench 12 to form the bit line 3; dry etching, wet etching, or a mixture of the two may be used. The bit line protective layers 14 are deposited on the bit lines 3, and the material of the bit line protective layers 14 may include, but is not limited to, silicon nitride, silicon oxide, silicon oxynitride, silicon carbonitride, and the like, or a combination thereof. The material of the bit line protective layers 14 is different from the material of the bit line isolation layers 8.

With reference to FIG. 4l, in some embodiments, the bit line isolation layers 8 are etched to form shield line trenches 15 in the bit line isolation layers 8. Specifically, since the bit line isolation layers 8 and the bit line protective layers 14 are made of different materials, a part of the bit line isolation layer 8 may be etched and removed by a self-aligned etching method to form the shield line trench 15, and dry etching, wet etching, or a mixture of the two may be used. In some embodiments, dry etching may be used first to form a trench with a certain depth; then wet etching is used, and same-direction etching is performed at the bottom of the trench, such that the width of the bottom of the trench is large, and thus the trench with different widths is formed, thereby preventing the problem of an open circuit caused by a failure to fill a shield line material due to a small trench bottom. The self-aligned etching process can reduce the number of photoetching processes, reduce production costs, and improve the stability of the device.

As can be seen from the foregoing steps, the greater the width of the bit line isolation layer 8 in the second direction, the greater the process window of the shield line trench 15, and the greater the depth of the shield line trench 15 in the third direction; the bottom of the shield line trench 15 is lower than a lowest plane of the bit line 3 in the third direction, such that a subsequently formed bit line shield line 16 can completely protect the bit line 3 from signal interference of an adjacent bit line. In some embodiments, the bottom of the shield line trench 15 may be lower than the lowest plane of the bit line contact 10 in the third direction, thereby improving the stability of the device. The shape of the shield line trench 15 is also not particularly limited. As an example, the cross-sectional shape of the shield line trench 15 in the second direction may be, for example, pyramidal, elongated, elliptical, star-shaped, or other suitable shapes.

With further reference to FIG. 2 and FIG. 3a to FIG. 3e, a conductive material is deposited in the shield line trenches 15 to form shield lines 16. In some embodiments, the shield lines 16 may each have a single layer, or may each have a plurality of layers. For example, in FIG. 3c, the shield line 16 may include a shield line first-material layer 1601 and a shield line second-material layer 1602, where the position relationship between the shield line first-material layer 1601 and the shield line second-material layer 1602 is not particularly limited. As an example, the shield line first-material layer 1601 and the shield line second-material layer 1602 may be in a stacked, surrounded, or half-surrounded relationship. The material of the shield lines 16 may include, for example, doped polycrystalline silicon, metal, conductive metal nitride, conductive metal silicide, conductive metal oxide, or a combination thereof. For example, the shield lines 16 may include, but are not limited to, doped polycrystalline silicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, or a combination thereof. Each shield line 16 includes at least one metal material layer, such that the resistance of the shield lines 16 can be reduced, and the performance of the device can be improved.

With further reference to FIG. 3b, in some embodiments, at least parts of each shield line 16 and each bit line isolation layer 8 are not in full contact, and there is a void 17 between the shield line 16 and the bit line isolation layer 8. The position of the void 17 relative to the shield line 16 and the bit line isolation layer 8 is not particularly limited. As an example, the void 17 may be located at the bottom or on one sidewall of the shield line, half-surround the shield line, or the like. The size and the shape of the void 17 are also not particularly limited. As an example, the void may be in the shape of a sphere, a droplet, a short tube, an ellipsoid, or a strip, or in other suitable shapes. Because the dielectric constant of the air is 1.001 and is close to the dielectric constant of vacuum, the void 17 and the bit line isolation layer 8 together demonstrate an effect of a low dielectric constant to reduce the overall dielectric constant, such that the parasitic capacitance can be reduced, and the capacitive coupling effect between the bit line 3 and an adjacent bit line 3 can be avoided, thereby reducing the influence of the parasitic capacitance on the performance parameter of the device.

With further reference to FIG. 3d, in some embodiments, the cross-sectional shape of the shield line 16 in the third direction may be the shape of an irregular structure, for example, may be pyramidal, elongated, elliptical, star-shaped, or other suitable shapes. The shield line is formed in the bit line isolation layer 8, and the size of the shield line 16 is influenced by the material of the bit line isolation layer 8 and the etching capability of the apparatus. The irregular structure of the shield line 16 can increase the process manufacturing window and reduce manufacturing process costs.

With further reference to FIG. 3e, in some embodiments, shield line barrier layers 18 may be further disposed above the shield lines 16, where the shield line barrier layers 18 cover the shield lines 16 and thus protect the shield lines 16 from being damaged in a subsequent process. The material of the shield line barrier layers 18 is not limited and may be the same as or different from the material of the bit line protective layers 14.

With further reference to FIG. 2, in some embodiments, the width D1 of the shield line 16 in the third direction (for example, the Z-direction) is not less than the width D2 of the bit line 3 in the third direction (for example, the Z-direction), or the width D1 of the shield line 16 in the third direction (for example, the Z-direction) exceeds the width D2 of the bit line 3 in the third direction (for example, the Z-direction). Optionally, the width D1 of the shield line 16 in the third direction (for example, the Z-direction) exceeds a sum of the widths of the bit line 3 and the bit line contact structure 10 in the third direction (for example, the Z-direction), such that the shield line 16 can completely shield the coupling effect between adjacent bit lines 3, thereby improving the performance of the device.

With further reference to FIG. 2, in some embodiments, the semiconductor structure may include a direct current bias (DC bias) power supply. The DC bias power supply and the shield lines 16 may be in contact through a connection (not shown) to provide a stable voltage to the shield line 16, such that the shield line 16 forms a conductive barrier, and thus when one of two adjacent bit lines 3 is powered on or off, the other bit line is less affected or unaffected.

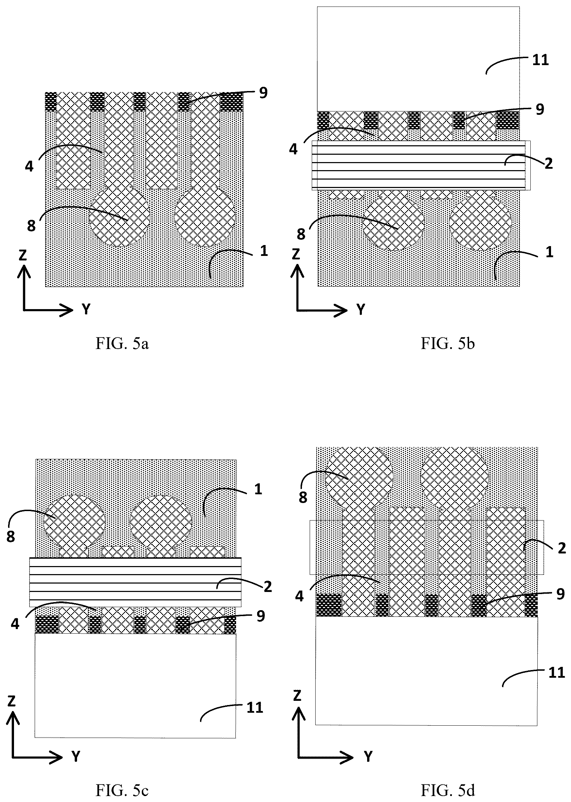

FIG. 5a to FIG. 5f are views showing intermediate steps describing a method for manufacturing a semiconductor memory device according to some embodiments. For convenience of description, parts that overlap with those described with reference to FIG. 4a to FIG. 4l will be briefly described or omitted. For reference, FIG. 5a is a view showing an intermediate step after FIG. 4d.

With reference to FIG. 5a, in some embodiments, the second bit line isolation trenches 603 are directly filled, and the material for filling the second bit line isolation trenches 603 is not particularly limited, which may be the same as or different from the material for filling the first bit line isolation trenches 602. A planarization process is performed to expose the first surface of the substrate 1, or to expose the top ends of the active pillars 4 in the case of incomplete filling, and memory contacts 9 are each formed at the top end of one active pillar. Specifically, the memory contacts 9 are formed by a suitable method, for example, ion implantation, deposition of a high-concentration doping material for diffusion, or deposition of a metal material for metal silicification reaction. The material of the memory contacts 9 is not particularly limited. As an example, the material of the memory contacts 9 may include at least one of doped polycrystalline silicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, and a combination thereof.

With reference to FIG. 1b and FIG. 5b, in some embodiments, word line isolation trenches 5 are formed by graphically etching the first surface of the substrate. The word line isolation trenches 5 and the bit line isolation trenches 6 form the active pillars 4. Word lines 2 are formed in the word line isolation trenches, and the word lines 2 extend along the second direction and are arranged in the first direction. The word lines surround the active pillars 4 and control the charge movement of the active pillars 4 on one, two, or three sides of the active pillars. The material of the word lines is not particularly limited. As an example, the material of the word lines 2 may include, for example, doped polycrystalline silicon, metal, conductive metal nitride, conductive metal silicide, conductive metal oxide, or a combination thereof. For example, the word lines 2 may include, but are not limited to, doped polycrystalline silicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, or a combination thereof.

A memory structure 11 is formed on the memory contacts 9, and a back end connection line (not shown) is formed on the memory structure 11. The memory structure 11 may be a capacitor structure. The capacitor includes upper and lower electrode plates and a high-K dielectric material between the upper and lower electrode plates; or may be a variable resistance memory structure. The variable resistance memory structure switches between two resistance states through the electric pulse applied to the memory element. For example, the variable resistance memory structure may include a phase change material, a perovskite compound, a transition metal oxide, a magnetic material, a ferromagnetic material, or an anti-ferromagnetic material, the crystalline state of which changes based on the amount of current.

With reference to FIG. 5c and FIG. 5d, in some embodiments, the substrate is turned over, the second surface of the substrate 1 is thinned, and a planarization process is performed with a first bit line isolation layer 8 as an etch stop layer.

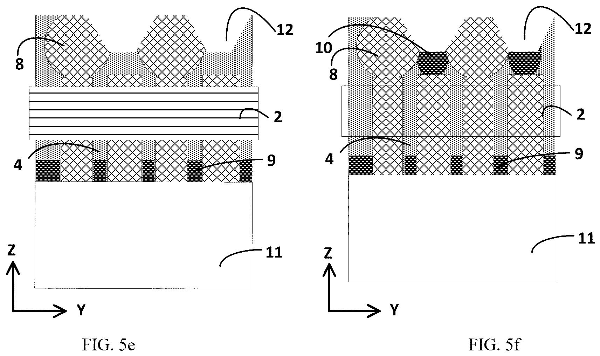

With reference to FIG. 5e, in some embodiments, since the bit line isolation layers 8 and the substrate are made of different materials, a self-aligned process may be adopted to selectively etch and remove a part of the substrate material to form bit line trenches 12. The self-aligned process can reduce the number of exposure and process costs.

With reference to FIG. 5f, in some embodiments, the bit line contacts 10 are each formed at the bottom of one bit line trench 12, and the bit line contacts 10 are formed by a suitable method, for example, ion implantation, deposition of a high-concentration doping material for diffusion, or deposition of a metal material for metal silicification reaction. The material of the bit line contacts 10 is not particularly limited. As an example, the material of the bit line contacts 10 may include at least one of doped polycrystalline silicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, and a combination thereof.

Subsequently, with reference to FIG. 4j to FIG. 4l, the bit lines 3 and the shield lines 16 are formed. In this way, the semiconductor memory device described with reference to FIG. 2 and FIG. 3a to FIG. 3e can be manufactured.

It should be noted that the methods for manufacturing a semiconductor structure provided in the embodiments of the present disclosure can all be used to manufacture the corresponding semiconductor structures. Therefore, the technical features between the method embodiments and the structure embodiments can be interchanged and supplemented without conflict, allowing those skilled in the art to learn the technical content of the present disclosure.

The technical features of the foregoing embodiments can be combined in any manner. For the sake of brevity, not all possible combinations of the technical features of the foregoing embodiments are described. However, as long as there is no contradiction in the combination of these technical features, they should all be considered within the scope of the present disclosure.

The foregoing embodiments merely express several implementations of the present disclosure. The descriptions are relatively specific and detailed, but they should not be construed as limiting the scope of the patent disclosure. It should be noted that for those of ordinary skill in the art, several modifications and improvements can be made without departing from the spirit of the present disclosure, and these should fall within the protection scope of the present disclosure. Therefore, the protection scope of the present patent disclosure should be defined by the appended claims.

## Claims

1. A semiconductor structure, comprising:
active pillars (4), wherein the active pillars (4) are arranged in an array in a first direction and a second direction, and the first direction intersects the second direction;
bit lines (3), wherein the bit lines (3) extend in the first direction, are spaced apart from each other in the second direction, and are connected to active pillars (4) arranged along the first direction;
shield lines (16), wherein the shield lines (16) are each located between two adjacent bit lines (3), extend in the first direction, and arranged alternately with the bit lines (3) in the second direction; and
bit line contact structures (10), wherein the bit line contact structures (10) are located between the bit lines (3) and the active pillars (4) and connect the bit lines (3) and the active pillars (4), and a width of each of the bit line contact structures (10) in the second direction is less than widths of each of the bit lines (3) and each of the active pillars (4) in the second direction.

2. The semiconductor structure according to claim 1, wherein each of the bit line contact structures (10) is connected to two of the active pillars (4) that are adjacent to each other in the second direction.

3. The semiconductor structure according to claim 1 or 2, wherein a width of each of the shield line (16) in a third direction is not less than a width of each of the bit lines (3) in the third direction, and the third direction intersects the first direction and the second direction.

4. The semiconductor structure according to claim 3, wherein the width of each of the bit lines (3) in the second direction decreases as the bit line (3) extends towards the bit line contact structure (10).

5. The semiconductor structure according to any one of claims 1 to 3, further comprising:
bit line protective layers (14), wherein the bit line protective layers (14) are each located on a side of one bit line (3) away from the bit line contact structure (10); and
bit line isolation layers (8), wherein the bit line isolation layers (8) are each located between two adjacent bit lines (3), and the shield lines (16) are located in the bit line isolation layers (8), wherein
the bit line protective layers (14) and the bit line isolation layer (8) are made of different materials.

6. The semiconductor structure according to any one of claims 1 to 3, wherein each of the bit lines (3) comprises at least one layer made of a metal material; and
each of the shield lines (16) comprises at least one layer made of a metal material.

7. The semiconductor structure according to any one of claims 4 to 6, further comprising:
shield line barrier layers (18), wherein the shield line barrier layers (18) cover the shield lines (16).

8. The semiconductor structure according to any one of claims 1 to 7, wherein there is a void (17) between each of the bit line isolation layers (8) and each of the shield lines (16).

9. The semiconductor structure according to any one of claims 1 to 8, wherein a cross-sectional shape of each of the shield lines (16) perpendicular to the first direction is pyramidal, elongated, elliptical, star-shaped, or other suitable shapes.

10. The semiconductor structure according to any one of claims 1 to 9, further comprising word lines (2), wherein the word lines (2) extend in the second direction and are spaced apart from each other in the first direction, and the word lines (2) are connected to active pillars (4) in the second direction; and
a memory structure (11), wherein the memory structure (11) is connected to the active pillars (4) and is located at one end of the active pillars (4) away from the bit lines (3).

11. A method for manufacturing a semiconductor structure, comprising:
forming active pillars (4), wherein the active pillars (4) are arranged in an array in a first direction and a second direction, and the first direction intersects the second direction;
forming bit lines (3), wherein the bit lines (3) extend in the first direction, are spaced apart from each other in the second direction, and are connected to active pillars (4) arranged along the first direction;
forming shield lines (16), wherein the shield lines (16) are each located between two adjacent bit lines (3), extend in the first direction, and are arranged alternately with the bit lines (3) in the second direction; and
forming bit line contact structures (10), wherein the bit line contact structures (10) connect the bit lines (3) and the active pillars (4), and a width of each of the bit line contact structures (10) in the second direction is less than widths of each of the bit lines (3) and each of the active pillars (4) in the second direction.

12. The method for manufacturing a semiconductor structure according to claim 11, wherein forming the bit lines (3) comprises:
providing a substrate (1), wherein the substrate (1) has a first surface and a second surface in a third direction, and the third direction intersects the first direction and the second direction;
forming bit line isolation trenches (6) by graphically etching the first surface, wherein a size of a bottom of each of the bit line isolation trenches (6) is greater than a size of a top of the bit line isolation trench (6), and the bit line isolation trenches (6) extend along the first direction and are spaced apart from each other in the second direction;
filling the bit line isolation trenches (6) to form bit line isolation layers (8);
polishing the second surface to expose the bit line isolation layers (8), and etching the substrate with the bit line isolation layers (8) as masks to form bit line trenches (12);
filling at least one layer made of a metal material into each of the bit line trenches (12) to form one bit line (3); and
forming bit line protective layers (14) on the bit lines (3), wherein the bit line protective layers (14) and the bit line isolation layers (8) are made of different materials.

13. The method for manufacturing a semiconductor structure according to claim 11 or 12, wherein forming the shield lines (16) comprises:
etching the bit line isolation layers (8) on the second surface with the bit line protective layers (14) as mask layers to form shield line trenches (15), wherein a depth of each of the shield line trenches (15) is not less than a depth of each of the bit line trenches (12); and
filling at least one layer made of a metal material into each of the shield line trenches (15) to form one shield line (16).

14. The method for manufacturing a semiconductor structure according to any one of claims 11 to 13, wherein each of the bit line contact structures (10) comprises a metal silicide, and forming the metal silicide comprises:
depositing a metal material layer at a bottom of each of the bit line trenches (12), and performing heat treatment to form the metal silicide; or
depositing a metal material layer at a bottom of each of the bit line isolation trenches (6), and performing heat treatment to form the metal silicide.

15. The method for manufacturing a semiconductor structure according to claim 12, wherein after filling the bit line isolation trenches (6) to form the bit line isolation layers (8), the method further comprises:
forming word line isolation trenches (5) by graphically etching the first surface, wherein a depth of each of the word line isolation trenches (5) is less than a depth of each of the bit line isolation trenches (6), the word line isolation trenches (5) extend along the second direction and are spaced apart from each other in the first direction, and the word line isolation trenches (5) and the bit line isolation trenches (6) form the active pillars (4); and
after forming the active pillars (4), the method further comprises:
forming word lines (2) in the word line isolation trenches (5), wherein the word lines (2) extend in the second direction and are spaced apart from each other in the first direction, and the word lines (2) are connected to active pillars (4) in the second direction; and
forming a memory structure (11) at one end of the active pillars (4) away from the bit lines (3).
